# EUROPEAN PATENT SPECIFICATION

(11) **EP 1 194 028 B1**
(45) Date of publication and mention of the grant of the patent: **28.07.2010**
(21) Application number: 01123451.5
(22) Date of filing: 28.09.2001
(51) Int. Cl.: H05K 13/02

(54) **Linear motor and electronic component feeding apparatus**
Linearmotor und Speisevorrichtung für elektronische Komponenten
Moteur linéaire et appareil d'alimentation de composant électronique

(30) Priority: 28.09.2000 JP 2000297315; 29.09.2000 JP 2000300338
(43) Date of publication of application: 03.04.2002
(73) Proprietor: Hitachi High-Tech Instruments Company, Ltd., Ora-gun Gunma 370-0596 (JP)
(72) Inventor: Kano, Yoshinori, Ora-gun, Gunma (JP); Inaoka, Osamu, Kakogawa-shi, Hyogo (JP); Yamaguchi, Haruhiko, Ota-shi, Gunma (JP); Kageyama, Shigeru, Nita-gun, Gunma (JP)
(74) Representative: Glawe, Delfs, Moll

(56) References cited:
- WO-A-00/36896
- GB-A- 2 326 981
- JP-A- 58 122 728
- US-A- 4 916 340

## Description

### BACKGROUND OF THE INVENTION

### Field of the invention

This invention relates to a linear motor having a moving member and a stationary member, and to an apparatus for feeding electronic components having at least one unit base capable of carrying at least one component feeding unit, a slide platen for sliding the unit base, and a linear motor comprising at least one stationary member mounted on the slide platen and a moving member mounted on the unit base.

Furthermore, this invention relates to an apparatus for feeding electronic components such as semiconductor chip components to an electronic component mounting instrument, especially to the apparatus for feeding electronic components in which a plurality of tape cassettes mounted laterally on a slide base move on a slide base. In detail, this invention relates to an apparatus for feeding electronic components having at least one unit base capable of carrying at least one component feeding unit, a slide platen for sliding the unit base, and a linear motor comprising at least one stationary member mounted on the slide platen through a supporting base for each of the stationary member and a moving member mounted on the unit base.

### Prior art

The electronic component feeding apparatus of this kind has been known to enables the high-speed transportation of the cassette base by the introduction of a linear motor as a driving mechanism inserted between the cassette base and the sliding slide platen (Japanese Patent Laid-Open Publication No. Sho 61-239696).

The linear motor of the aforementioned development comprises a pair of stationary members attached to the slide platen and a moving member attached to the bottom surface of the cassette base, and is configured such that the moving member is sandwiched between the two stationary members in the pair. The stationary member consists of a plurality of magnets aligned along the longitudinal direction of the slide platen, and the moving member consists of a core made of magnetic material and coils wound around the core.

Although the high-speed transportation of the cassette base was achieved by the introduction of linear motor described above, the moving member of the motor generates heat upon continuous operation of the motor. That is, when the motor is operated continuously beyond the allowance maximum (operated with large effective power), the motor generates heat and stops at a predetermined capacity point for preventing the motor from burning. If the motor is constructed in such a way that it endures necessary continuous operation, the size of the motor becomes large. Also when the heat is transmitted to other surrounding structures, an expansion of the structures occurs which then cause the deterioration of the accuracy in component mounting.

From WO 00/36896 it is.known to arrange cooling ducts in the vicinity of the electromotor drives. In GB 2 326 981 a linear motor with a moving aluminium block is disclosed.

### SUMMARY OF THE INVENTION

It is thus an object of the invention to provide an apparatus for feeding electronic components and a linear motor with improved heat dissipation.

The invention lies in the features of the independent claims and preferably in those of the dependent claims.

Also, in the apparatus for feeding electronic components having at least one unit base capable of carrying at least one component feeding unit which successively supplies electronic components loaded in carrier tape at predetermined pitch to the component pick-up position, a slide platen for sliding the unit base thereon, and a linear motor comprising at least one stationary member mounted on the slide base and a moving member on the unit base, a heat dissipation portion is formed in the moving member mounted on the unit base.

Therefore, the embodiments of this invention are directed to dissipating heat from the moving member, which is the heat source of the linear motor and to suppressing the temperature rise as much as possible. Thus, the linear motor comprising a stationary member and a moving member of the embodiments include a heat dissipation portion formed in the moving member.

The heat dissipation portion is formed in such a way that the heat dissipation portion pierces through the iron core of the moving member.

Also, the heat dissipation portion is formed in such a way that the heat dissipation portion pierces through the center of the iron core of the moving member and has a heat dissipation fin at one end.

Additionally, in the apparatus for feeding electronic component having at least one unit base capable of carrying at least one component feeding unit, a slide platen for sliding the unit base, and a linear motor comprising at least one stationary member mounted on the slide platen and a moving member mounted on the unit base, a heat dissipation portion is formed on the unit base for dissipating the heat in the moving member.

Also, the heat dissipation portion is the heat dissipation fin which forms a unitary unit with the unit base.

Furthermore, the embodiments are directed to preventing the deterioration of the accuracy in component mounting by cooling the moving member which is the heat source of the linear motor. Thus, in the apparatus for feeding electronic component having at least one unit base capable of carrying at least one component feeding unit, a slide platen for sliding the unit base thereon, and a linear motor comprising at least one stationary member mounted on the slide platen through a supporting base for each of the stationary member and a moving member mounted on the unit base, the moving member is cooled by the air sent from a ventilator and passing through the air supplying passage formed in the slide platen for blowing against the moving member through the air exhaust port formed in the slide platen.

Also, in the apparatus for feeding electronic components having at least one unit base capable of carrying at least one component feeding unit which successively supplies electronic components loaded in carrier tape at predetermined pitch to the component pick-up position, a slide platen for sliding the unit base thereon, and a linear motor comprising at least one stationary member mounted on the slide base through a supporting base for each of the stationary member and a moving member on the unit base, a cutter for cutting carrier tape after electronic components are picked up, and a collection box for collecting tape cut off by the cutter by the sucking air through a inhalation duct using ventilator are equipped. The air from the ventilator is lead to the air supplying passage formed in the slide platen through an exhaust duct, and then blown to the moving member through the air exhaust port formed in the slide platen to cool the moving member.

Additionally, the air exhaust port is formed in the slide platen within the range where the unit base moves for feeding components. Also, the air exhaust port is covered with a filter.

### BRIEF DESCRIPTION OF THE DRAWING

Fig. 1 is a side view of a high-speed electronic component mounting instrument equipped with an electronic component feeding apparatus as the first embodiment of this invention.
Fig. 2 is a perspective external view of the electronic component feeding apparatus as the first embodiment of this invention.
Fig. 3 is an expanded cross-sectional view of the electronic component feeding apparatus as the first embodiment of this invention.
Fig. 4 is a cross-sectional view at the plane involving the stationary members of the electronic component feeding apparatus as the first embodiment of this invention.
Fig. 5 is a plan view showing a partial cross-section of the main portion of the electronic component feeding apparatus as the first embodiment of this invention.
Fig. 6 is a plan view of the main portion of the electronic component feeding apparatus as the first embodiment of this invention.
Fig. 7 is a front view of the main portion of the electronic component feeding apparatus as the first embodiment of this invention.
Fig. 8 is a front view of the main portion of the electronic component feeding apparatus as the first embodiment of this invention.
Fig. 9 is a front view of the main portion of the electronic component feeding apparatus as the first embodiment of this invention.
Fig. 10 is a cross-sectional view of the linear motor of the second embodiment of this invention.

### DETAILED DESCRIPTION OF THE PREFERRED EMBODIMENTS

First, an apparatus for feeding electronic components working as a part of a high-speed electronic component mounting instrument will be described as the first embodiment of this invention in reference to the above figures.

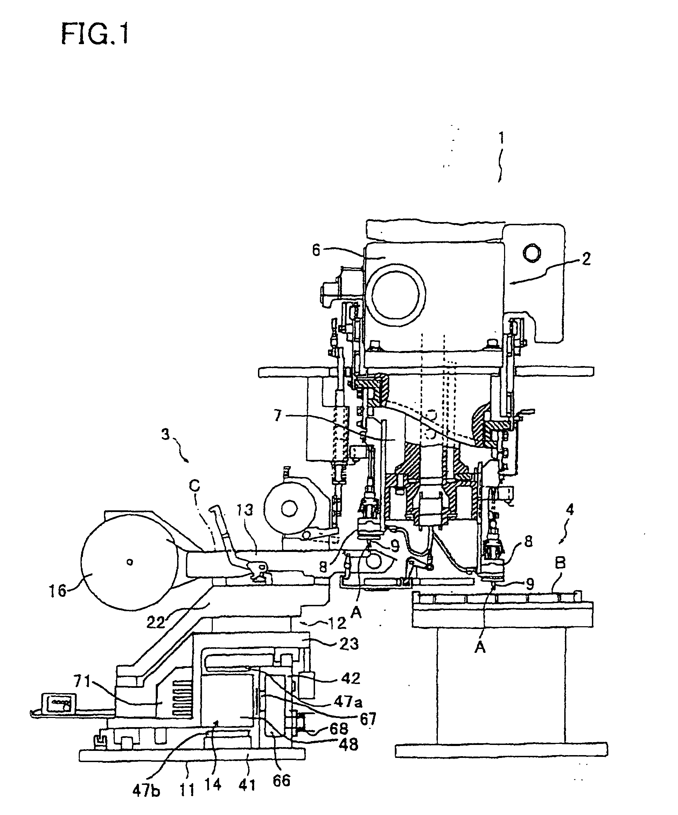

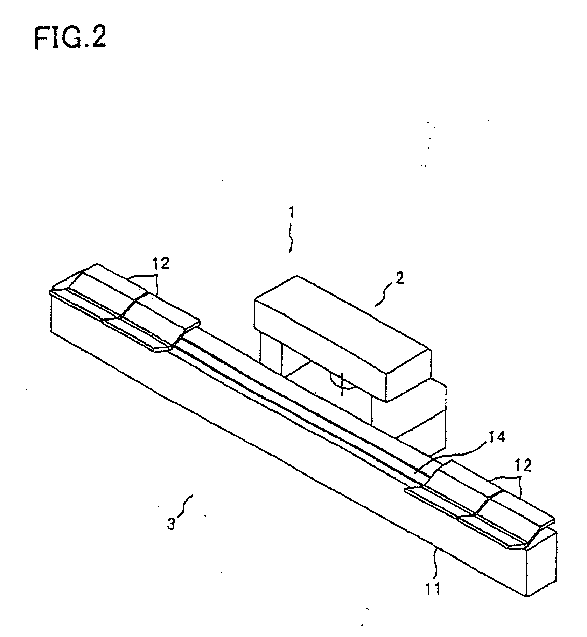

Fig. 1 is a side view of a high-speed electronic component mounting instrument, and Fig. 2 is a perspective external view of the feeding constituent of the mounting instrument. As seen from both figures, the high-speed electronic component mounting instrument consists of an apparatus main body 2, a feeding portion 3 for feeding electronic components A, and a mounting portion 4 for mounting electronic components A to print board B, in such a way that the feeding portion 3 and the mounting portion 4 are aligned parallel along the main body 2, having the main body 2 in between. The feeding portion 3 includes an apparatus for feeding electronic components as shown in the figures.

The main body 2 includes an index unit 6 as a main portion of a driving system, a rotating table 7, and a plurality of mounting heads 8 (12 in this embodiment) placed at the outer portion of the rotating table 7. The index unit 6 rotates the rotating table 7 intermittently with a pitch in accordance with the number of the mounting heads 8. As the rotating table rotates intermittently, a suction nozzle 9 placed on each mounting head 8 comes to the feeding portion 3 for picking up electronic component A provided by the feeding portion by suction, transports the electronic component A to the mounting portion 4, and mounts the electronic component A on print board B at the mounting portion 4.

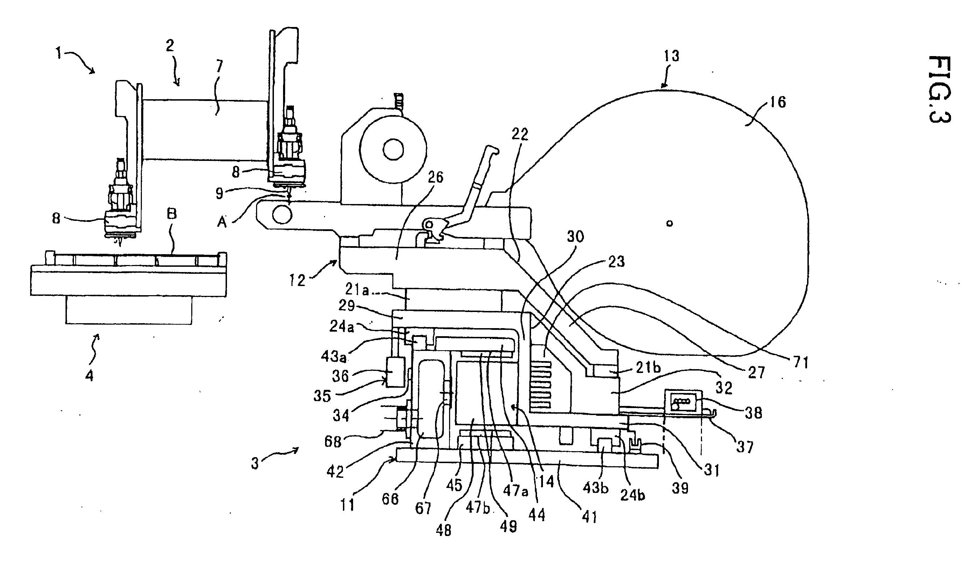

The feeding portion 3, which is basically the apparatus for feeding the electronic components, includes a slide platen 11 with its longitudinal direction being perpendicular to the plane of the figures (Fig. 1 and Fig. 3), four slide bases (unit bases) 12 mounted on the slide platen 11 for sliding thereon, a plurality of tape cassettes (component feeding unit) 13 detachably mounted on the slide base 12, and a linear motor 14 placed between the slide platen 11 and each slide base 12.

As shown in Fig. 2, among the four slide bases 12, one pair of the slide bases 12 rests at one end of the slide platen 11 and another pair rests at the other end. During the operation, the two pairs of the slide bases 12 with each slide base 12 carrying a group of tape cassettes 13 come to the main body 2 alternatively. While one pair with each slide base 12 carrying a group of tape cassettes 13 moves (slides) to the position of the main body 2 and rests there for component feeding operation, another pair is at the home position (one end of the slide platen) for changing the tape cassettes 13 in preparation for the next feeding operation. Fig. 2 shows the pair of slide bases 12 without groups of tape cassettes 13.

As seen from and Fig. 3, each tape cassette 13 is designed to be thin so that a group of the tape cassettes 13 can be mounted on the upper surface of the slide base 12 being laterally oriented (perpendicular to the longitudinal direction of the slide platen) with a narrow space among them. Each tape cassette 13 has its designated position on the upper surface of the slide base 12 and can easily be attached to or detached from the position by a simple lever operation. The mounting head 8 (suction nozzle 9) of the apparatus main body 2 comes to the opposite end of the tape cassette 13 mounted on the slide base 12 to the tape reel 16 for picking up the electronic component A. The tape cassette 13 has carrier tape C with electronic components A being contained therein at a predetermined pitch, which is wound to a tape reel 16. The electronic components A are picked up one by one by the suction nozzle 9 from the carrier tape C, which is unreeled from the tape reel 16.

The slide base 12 consists of base block 22 (upper portion) fixed at a proper position by the left and right joint portions 21a, 21b, and a slide block 23 (lower portion). The tape cassette 13 described above is mounted on the upper surface of the base block 22, and a pair of sliders 24a, 24b are placed at the lower surface of the slide block 23 at its both ends. The base block 22 has a horizontal portion 26 and a slant portion 27, which form a unitary unit, and is configured in such a way that the slant portion 27 makes room for the tape reel 16 which is a part of the tape cassette 13 mounted on the horizontal portion 26.

The slide block 23 consists of an upper horizontal portion 29, a vertical portion 30, and a lower horizontal portion 31, with its vertical cross-section having a crank-like shape. The proper number of rib portions 32 are formed outwardly at proper locations between the vertical portion 30 and the lower horizontal portion 31 in such a way that the rib portions 32 make room for heat dissipation fin 71 described hereinafter. The upper horizontal portion 29 supports the horizontal portion 26 of the base block 22 through the one joint portion 21a, and the rib portion 32 supports the slant portion 27 of the base block 22 through another joint portion 21b. A first slider 24a is fixed at the outermost lower surface of the upper horizontal portion 29, and a second slider 24b is fixed at the outermost lower surface of the lower horizontal portion 31.

Reference numeral 71 denotes a heat dissipation fin (heat dissipation portion) for making the heat dissipation area larger. The heat dissipation fin 71 extrudes from the vertical portion 30 of the slide block 23, faces the rib portion 32, and forms a unitary unit with the slide block 23. The slide block 23 including the heat dissipation fin 71 is made of the material with efficient thermal conduction such as aluminum for dissipating heat from the moving member 48. The lateral length of the heat dissipation fin 71(the lateral length viewing from the front side of the electronic component mounting instrument) is about the same length of the moving member 48.

Furthermore, there is a linear encoder 35 consisting of a scale 34 placed on the slide platen 11 and a photo sensor 36 placed at the outermost lower surface of the upper horizontal portion 29. On the outermost upper surface of the lower horizontal portion 31, there is a terminal for a cableveyor 38 for supplying the control signals and electric power to the linear motor 14 through the bracket 37. There is also a photo interrupter 39 for detecting the slide base 12 when it overruns its home position.

The slide platen 11 consists of a slide platen main body 41 and a vertical block 42. At the edge of the upper surface of the vertical block 42 is placed a first slide rail 43a for engaging with the first slider 24a. Likewise, at the edge of the upper surface of the slide platen main body 41 is placed a second slide rail 43b for engaging with the second slider 24b. Furthermore, on the upper surface of the vertical block 42 is fixed an upper supporting base 44 for the magnets extending horizontally toward the vertical portion 30 of the slide block 23. A lower supporting base 45 for the magnets is also placed on the upper surface of the slide platen main body 41 at a position corresponding to the upper supporting base 44.

The linear motor 14 consists of a pair of upper and lower stationary members 47a, 47b fixed on the slide platen 11, and a moving member 48 fixed on the slide base 12. The stationary members 47a and 47b consist of upper and lower supporting bases 44, 45 and upper and lower magnets 49. Among the pair of magnets 49, the upper magnet 49 is fixed downwardly on the lower surface of the upper supporting base 44 and the lower magnet 49 is fixed upwardly on the upper surface of the lower supporting base 45. On the other hand, the moving member 48 is similar to the slide base 12 in its length, and fixed on the sidewall of the vertical portion 30 of the slide block 23. As seen from the figure, the upper surface of the moving member 48 is in close proximity (air gap) to the upper stationary member 47a, and the lower surface to the lower stationary member 47b. In summary, the moving member 48 and the pair of upper and lower stationary members 47a, 47b, as a whole and facing to each other, form a linear motor 14.

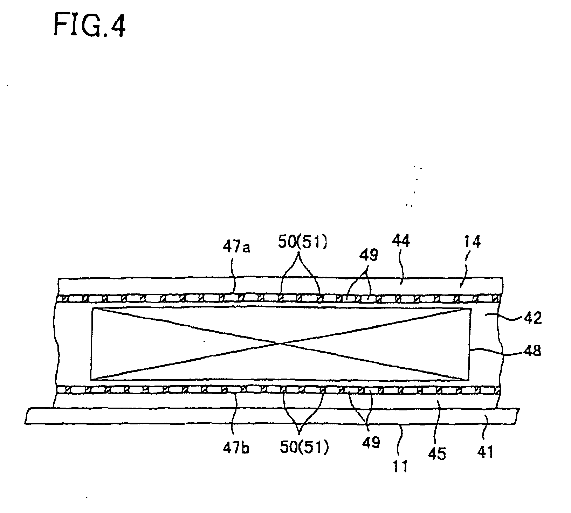

The moving member 48 fixed on each slide block 23 consists of a core structure made of magnetic material and coils wound around the core (although it is not shown in the figure, an iron core made of magnetic material can be used around which coils are wound). On the other hand, the upper and lower stationary members 47a and 47b consist of a plurality of magnets 49 aligned along the longitudinal direction of the upper and lower supporting bases 44 and 45, as shown in Fig. 4. These magnets 49 are aligned with a short and constant pitch, and space between the magnets 50 is filled with a resin molding 51, in such a way that each surface of the upper and lower stationary members 47a and 47b makes a flat surface.

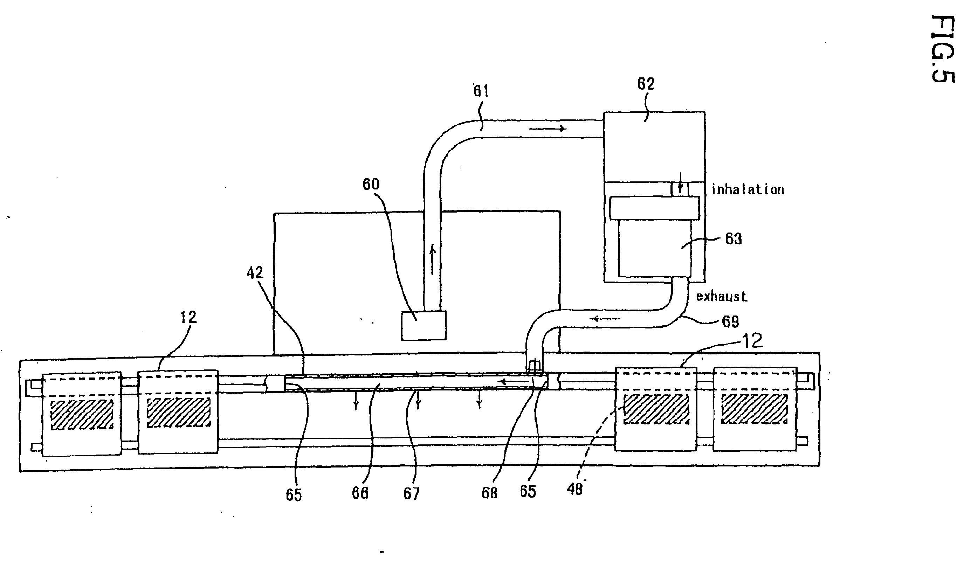

Reference numeral 60 in Fig. 5 denotes a cutter which cuts carrier tape C at a predetermined pitch after electronic components are picked up by the suction nozzle 9 and located at the lower part of the component pick-up position. Waste tapes cut off by the cutter 60 are collected in a collection box 62 through an inhalation duct 61. As seen in the figure, for facilitating the tape collection procedure, an inhalation ventilator 63 is placed under the collection box 62.

The vertical block 42, one of the portions of the slide platen 11, is hollow and sealed at the both ends with sealing portion 65 to make an air supplying passage 66. The hollow part is constructed in such a way that the hollow part is longer than the range where a pair of slide bases 12 moves during a component pick-up operation. Also, in the hollow part of the vertical block 42, within the range where a pair of slide bases 12 moves during the component pick-up operation, three, for example, circular air exhaust ports 67 facing to the moving member 48 and an air inhalation port 68 facing to the mounting portion 4 are formed.

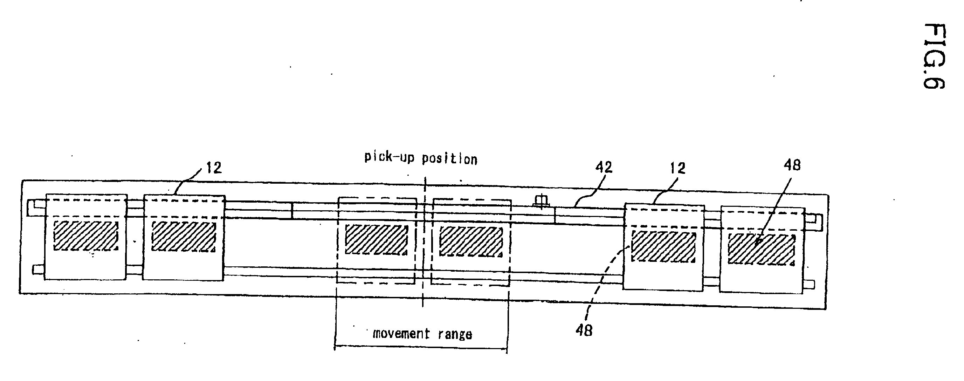

That is, the operation with frequent starts and stops (the operation with large effective power) of the linear motor takes place near the component pick-up position. The operation of the linear motor at other parts does not cause large heat generation. For effectively cooling the area near the component pick-up position, where large heat generation may take place, and also for decreasing the consumption of air flux as seen in Fig. 6, the air exhaust port 67 facing to the moving member 48 is formed within the range where a pair of the slide bases 12 moves during the component pick-up operation. By forming the air exhaust port 67, the air coming from the air exhaust port is not wasted and the consumption of air flux can also be decreased.

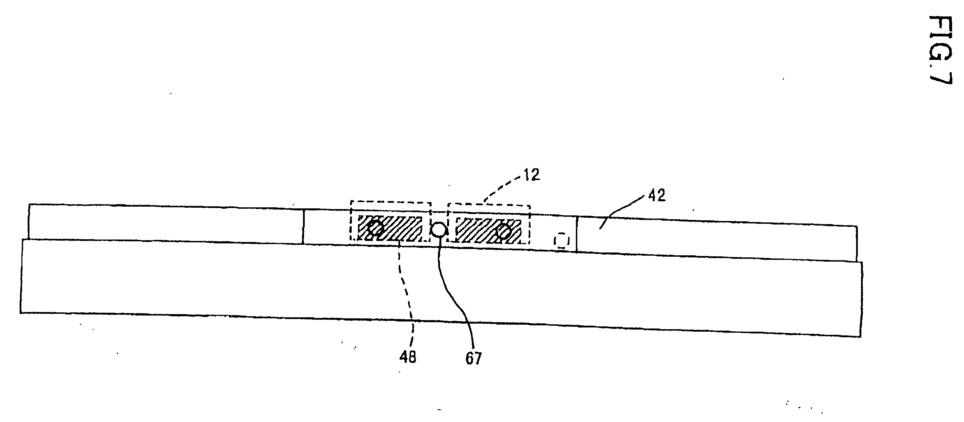

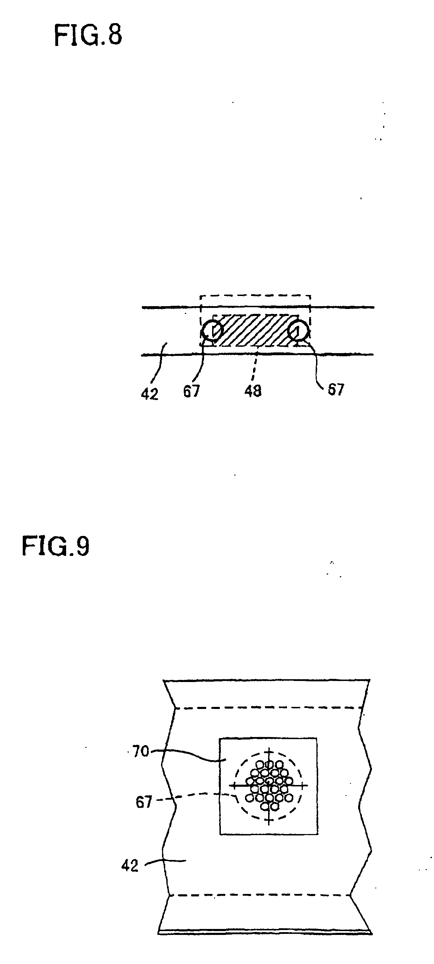

Also, as shown in Fig. 8, the length of the transverse direction of the moving member 48 is the same as the length between the centers of the two air exhaust ports 67. Also as shown in Fig. 7, even if the central air exhaust port 67 comes to the location between a pair of slide bases 12 (two moving members 48), the air from both right and left air exhaust ports 67 is blown to the both moving members 48.

Additionally, the air inhalation port 68 and the inhalation ventilator 63 are connected with exhaust duct 69. The waste tape cut off by the cutter 60 is lead to the collecting box 62 through the inhalation duct 61 by sucking air by the inhalation ventilator 63. At the same time, the air from the ventilator 63 is lead to the air supplying passage 66 through the exhaust duct 69 and then to the moving member 48 through the air exhaust port 67 to cool the moving member 48. Since the inhalation ventilator 63 for collecting waste tape in the collection box is also used to cool the moving member 48 as described above, it is not necessary to construct an additional ventilator for cooling. The cooling system of the moving member of this invention can be small sized and less expensive.

Numeral reference 70 indicates a filter covering the air exhaust port 67 from the outer side of the port and capable of catching small pieces of tape coming through the collection box 62 as well as the debris from electronic components.

Now, the production operation will be described hereinafter. First, the motor driver starts driving the linear motor 14 based on a production initiator command from CPU (not shown in figures) which is a control apparatus. At this moment, the linear motor 14 is being driven based on the proper velocity loop gain. The movement of the linear motor 14 is monitored by the encoder 35, which feeds the result of the measurement back to the differential counter and the velocity control unit (both not shown in figures).

After the slide base 12 comes to the apparatus main body 2, the mounting head 8 (suction nozzle 9) picks up electronic component A from a proper tape cassette 13, moves to print board B by the rotation of the rotating table 7 while holding electronic component A, and mounts electronic component A on a proper position of print board B. This mounting operation is repeated for mounting other component A on print board B. Then, the carrier tape C is cut by the cutter 60 with a predetermined pitch after electronic component is picked up by the suction nozzle 9, and waste tapes are lead to the collection box 62 through the inhalation duct 61. The inhalation ventilator 63 is operated only during the operation of a pair of the slide bases 12 and stopped when the slide base stops for decreasing the consumption of air flux.

Therefore, by the operation of the inhalation ventilator 63, waste tapes cut off by the cutter 60 are collected in the collection box 62 through inhalation duct 61. Furthermore, the air from the ventilator 63 is lead to the air supplying passage 66 through the exhaust duct 69 and blown to the moving member 48 through the air exhaust port 67 to cool the moving member 48.

Also, as a pair of the slide bases 12 moves, the heat dissipation fin 71 formed on the vertical portion 30 of the slide block 23 receives the air and the heat in the moving member 48 is further dissipated.

The filter 70 catches small pieces of tape coming through the collection box 62 as well as the debris from electronic components.

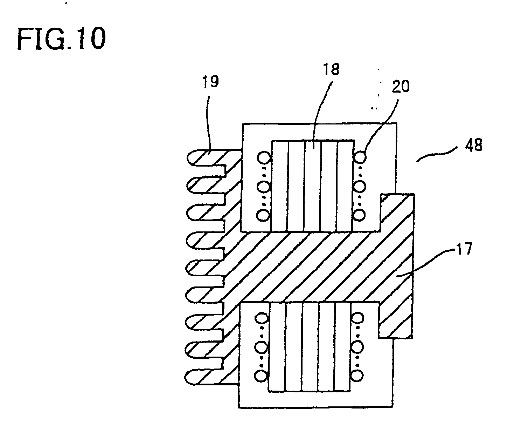

The structure of the moving member 48 of the linear motor as the second embodiment will be explained hereinafter in reference to Fig. 10.

The moving member 48 comprises an iron core 18 as a structure made of magnetic material, coils 20 wound around the core and an axis 17 which is a heat dissipation portion made of the materials with efficient thermal conduction such as aluminum, and which pierces through the center of the iron core, and is molded with synthetic resin except a part of the axis 17. At one end of the axis 17, a heat dissipation fin 19 is formed to make heat dissipation area larger. The moving member 48 is placed in such a way that the aforementioned heat dissipation fin 19 faces the air exhaust port 67.

When the coils generate heat, the heat is transmitted from the coils to the iron core 18 and then to the axis 17 piercing through the center of the iron core 18 and dissipated through the heat dissipation fin 19 resulting in the suppression of the temperature rise. The heat in the outermost part of the iron core 18 from the heat dissipation fin 19 is also transmitted through the heat dissipation fin 19 through the axis 17 suppressing the temperature rise of the moving member 48 as a whole. As a result, the deterioration of the accuracy in component mounting is avoided.

Within the range where components are picked up by suction, the air from the ventilator 63 coming through the air exhaust port 67 is blown to the moving member 48, especially to their heat dissipation fin 19, so that the heat in the moving member 48 can be dissipated. As a pair of the slide bases 12 moves, the slide block 23 on which the moving member 48 is fixed also moves along with this movement, the air is blown to the heat dissipation fin 19 so that the heat in the moving member 48 is dissipated.

In the second embodiment described above, the temperature rise in the moving member 48 is suppressed by the heat dissipation portion (heat dissipation fin 19) formed in the moving member 48 itself.

Also by combining the heat dissipation fin 19 and the heat dissipation fin 71 mounted on the slide base 12 (slide block 23) with the moving member 48 thereon of the first embodiment, the heat dissipation is further improved.

Although as the second embodiment, the moving member 48 comprising the iron core and the axis 17 (heat dissipation portion) with the heat dissipation fin 19 at one end which pierces through the center of the iron core is introduced, this invention is not limited to this embodiment. For example, the axis (heat dissipation portion without heat dissipation fin 19) piercing through the iron core 18 of the moving member 48 can be constructed in such a way that one end of the axis exposes to the outside of the moving member 48. Also, the axis can be constructed in such a way that at least a part of the axis touches the iron core 18, but does not necessarily pierces through the iron core 18.

Also, by mounting the heat dissipation portion (heat dissipation fin without the axis 17) on the outer surface of the molded moving member 48, the temperature rise of the moving member can be indirectly suppressed.

In this embodiment, the electronic component feeding apparatus is used for a high-speed electronic component mounting instrument. However, this invention is also applicable to multi purpose electronic component mounting instrument which mounts surface mount components such as chip condenser and chip resistor, multi lead components such as flat packaged IC and other electronic components to a print board. Also, this electronic component feeding apparatus is applicable when bulk cassettes, instead of tape cassettes, are mounted.

While the invention has been described and illustrated with respect to a few embodiments, it will be understood by those skilled in the art that various other changes and modifications may be made without departing from the scope of this invention as defined by the following claims.

## Claims

1. An apparatus for feeding electronic components comprising:
- at least one unit base (12) capable of carrying at least one component feeding unit (13);
- a platen (11) for sliding the unit base thereon; and
- a linear motor (14) comprising at least one stationary member mounted on the platen (11) and a moving member mounted on the unit base (12);
- a heat dissipation portion formed on the unit base (12) for dissipating the heat in the moving member (48).
**characterized in that**
- the moving member (48) comprises a core (18) made of a magnetic material and coils (20) wound around the core (28) and at least a part of the heat dissipation portion (17) is touching the core (18); and
- that the heat dissipation portion (17) pierces through the core of the moving member (48).

2. The apparatus for feeding electronic components of claim 1, wherein the heat dissipation portion comprises a heat dissipation fin (71) which forms a unitary unit with the unit base (12).

3. The apparatus for feeding electronic components of claim 1, wherein the heat dissipation portion (17) pierces through the center of the core (18) of the moving member (48) and a heat dissipation fin (19) is formed at one end of the heat dissipation portion (17).

4. The apparatus for feeding electronic components of one of the previous claims, wherein air from a ventilator (63) is lead to an air supplying passage (66) formed within the platen and blown to the moving member (48) through an air exhaust port (67) formed in the platen (11) for cooling the moving member (48).

5. The apparatus for feeding electronic components of claim 4, further comprising a cutter (60) which cuts a carrier tape (C) after the electronic components is picked up; and
a collection base (62) which collects waste tapes cut off by the cutter (60) by sucking air through an inhalation duct (61) using the ventilator (63) wherein the air is lead to the air supplying passage (66) through an air exhaust duct (69).

6. The apparatus for feeding electronic component of claims 4 or 5, wherein the air exhaust port (67) is formed in the platen (11) within a range where the unit base (12) moves during a component pick-up operation.

7. The apparatus for feeding electronic component of claims 4, 5 or 6, wherein the air exhaust port (67) is covered with a filter (70).

8. A linear motor comprising:
- a moving member (48) comprising a core (18) made of a magnetic material and coils (20) wound around the core;
- a stationary member, said moving member (48) being slidably engaged with the stationary member; and
- a heat dissipation portion;
wherein at least a part of the heat dissipation portion touches the core (18) and wherein the heat dissipation portion pierces through the core (18) of the moving member (48).

9. The linear motor of claim 8, wherein the heat dissipation portion pierces through a center of the core (18) of the moving member (48) and at one end of the heat dissipation portion is formed a heat dissipation fin (19).

## Patentansprüche

1. Vorrichtung zum Zuführen von elektronischen Bauelementen umfassend:
- mindestens eine Basiseinheit (12), die mindestens eine Bauelementzuführeinheit (13) tragen kann;
- eine Platte (11) zum Verschieben der Basiseinheit darauf; und
- einen Linearmotor (14), der mindestens ein auf der Platte (11) montiertes stationäres Glied und ein auf der Basiseinheit (12) montiertes bewegliches Glied umfasst;
- einen Wärmeabführteil, der auf der Basiseinheit (12) zum Abführen der Wärme in dem beweglichen Glied (48) ausgebildet ist,
**dadurch gekennzeichnet, dass**
- das bewegliche Glied (48) einen Kern (18), der aus einem magnetischen Material hergestellt ist, und Spulen (20), die um den Kern (18) herum gewickelt sind, umfasst und mindestens ein Teil des Wärmeabführteils (17) den Kern (18) berührt; und
- der Wärmeabführteil (17) den Kern des beweglichen Glieds (48) durchdringt.

2. Vorrichtung zum Zuführen von elektronischen Bauelementen nach Anspruch 1, wobei der Wärmeabführteil eine Wärmeabführrippe (71) umfasst, die eine einteilige Einheit mit der Basiseinheit (12) bildet.

3. Vorrichtung zum Zuführen von elektronischen Bauelementen nach Anspruch 1, wobei der Wärmeabführteil (17) die Mitte des Kerns (18) des beweglichen Glieds (48) durchdringt und eine Wärmeabführrippe (19) an einem Ende des Wärmeabführteils (17) ausgebildet ist.

4. Vorrichtung zum Zuführen von elektronischen Bauelementen nach dem vorhergehenden Anspruch, wobei Luft von dem Ventilator (63) zu einem in der Platte ausgebildeten Luftzufuhrkanal (66) geleitet und durch eine in der Platte (11) ausgebildete Luftauslassöffnung (67) zu dem beweglichen Glied (48) geblasen wird, um das bewegliche Glied (48) zu kühlen.

5. Vorrichtung zum Zuführen von elektronischen Bauelementen nach Anspruch 4, ferner mit einer Schneidvorrichtung (60), die nach Aufnahme der elektronischen Bauelemente ein Trägerband (C) schneidet; und
einer Sammelbasis (62), die von der Schneidvorrichtung (60) abgeschnittenen Bandabfall sammelt, indem unter Verwendung des Ventilators (63) Luft durch einen Inhalationskanal (61) angesaugt wird, wobei die Luft durch einen Luftauslasskanal (69) zu dem Luftzufuhrkanal (66) geleitet wird.

6. Vorrichtung zum Zuführen von elektronischen Bauelementen nach Anspruch 4 oder 5, wobei die Luftauslassöffnung (67) in einem Bereich in der Platte (11) ausgebildet ist, in dem sich die Basiseinheit (12) während eines Bauelementaufnahmevorgangs bewegt.

7. Vorrichtung zum Zuführen von elektronischen Bauelementen nach Anspruch 4, 5 oder 6, wobei die Luftauslassöffnung (67) mit einem Filter (70) bedeckt ist.

8. Linearmotor, der Folgendes umfasst:
- ein bewegliches Glied (48), das einen Kern (18), der aus einem magnetischen Material hergestellt ist, und Spulen (20), die um den Kern herum gewickelt sind, umfasst;
- ein stationäres Glied, wobei das bewegliche Glied (48) mit dem stationären Glied in Gleiteingriff steht; und
- einen Wärmeabführteil;
wobei mindestens ein Teil des Wärmeabführteils den Kern (18) berührt und wobei der Wärmeabführteil den Kern (18) des beweglichen Glieds (48) durchdringt.

9. Linearmotor nach Anspruch 8, wobei der Wärmeabführteil eine Mitte des Kerns (18) des beweglichen Glieds (48) durchdringt und an einem Ende des Wärmeabführteils eine Wärmeabführrippe (19) ausgebildet ist.

## Revendications

1. Dispositif pour faire avancer des composants électroniques comprenant :
- au moins une base d'unité (12) capable de supporter au moins une unité d'avance de composants (13) ;
- un plateau (11) pour faire coulisser la base d'unité sur celui-ci ; et
- un moteur linéaire (14) comprenant au moins un élément fixe monté sur le plateau (11) et un élément mobile monté sur la base d'unité (12) ;
- une partie de dissipation de chaleur formée sur la base d'unité (12) pour dissiper la chaleur dans l'élément mobile (48),
**caractérisé en ce que**
- l'élément mobile (48) comprend un noyau (18) réalisé en un matériau magnétique et des bobines (20) enroulées autour du noyau (28) et au moins une partie de la partie de dissipation de chaleur (17) touche le noyau (18) ; et
- **en ce que** la partie de dissipation de chaleur (17) transperce le noyau de l'élément mobile (48).

2. Dispositif pour faire avancer des composants électroniques selon la revendication 1, dans lequel la partie de dissipation de chaleur comprend une ailette de dissipation de chaleur (71) qui forme une unité unitaire avec la base d'unité (12).

3. Dispositif pour faire avancer des composants électroniques selon la revendication 1, dans lequel la partie de dissipation de chaleur (17) transperce le centre du noyau (18) de l'élément mobile (48) et une ailette de dissipation de chaleur (19) est formée à une extrémité de la partie de dissipation de chaleur (17).

4. Dispositif pour faire avancer des composants électroniques selon l'une des revendications précédentes, dans lequel de l'air provenant d'un ventilateur (63) est amené vers un passage d'alimentation en air (66) formé dans le plateau et soufflé vers l'élément mobile (48) à travers un orifice d'évacuation d'air (67) formé dans le plateau (11) pour refroidir l'élément mobile (48).

5. Dispositif pour faire avancer des composants électroniques selon la revendication 4, comprenant en outre un couteau (60) qui coupe une bande de support (C) après que les composants électroniques ont été retirés ; et
une base de collecte (62) qui recueille les déchets de bande coupés par le couteau (60) en aspirant l'air à travers un conduit d'inhalation (61) en utilisant le ventilateur (63), dans lequel l'air est amené vers le passage d'alimentation en air (66) à travers un conduit d'évacuation d'air (69).

6. Dispositif pour faire avancer des composants électroniques selon la revendication 4 ou 5, dans lequel l'orifice d'évacuation d'air (67) est formé dans le plateau (11) dans une plage où la base d'unité (12) se déplace pendant une opération de retrait de composants.

7. Dispositif pour faire avancer des composants électroniques selon la revendication 4, 5 ou 6, dans lequel l'orifice d'évacuation d'air (67) est recouvert d'un filtre (70).

8. Moteur linéaire comprenant :
- un élément mobile (48) comprenant un noyau (18) réalisé en un matériau magnétique et des bobines (20) enroulées autour du noyau ;
- un élément fixe, ledit élément mobile (48) étant mis en prise de manière coulissante avec l'élément fixe ; et
- une partie de dissipation de chaleur ;
dans lequel au moins une partie de la partie de dissipation de chaleur touche le noyau (18), et dans lequel la partie de dissipation de chaleur transperce le noyau (18) de l'élément mobile (48).

9. Moteur linéaire selon la revendication 8, dans lequel la partie de dissipation de chaleur transperce un centre du noyau (18) de l'élément mobile (48) et, à une extrémité de la partie de dissipation de chaleur, une ailette de dissipation de chaleur (19) est formée.
